# EUROPEAN PATENT APPLICATION

(11) **EP 2 207 213 A1**
(43) Date of publication of application: **14.07.2010**
(21) Application number: 08838684.2
(22) Date of filing: 07.10.2008
(51) Int. Cl.: H01L 35/32, H01L 35/22, H02N 11/00

(54) **THERMOELECTRIC CONVERSION MODULE**

(30) Priority: 15.10.2007 JP 2007268248
(71) Applicant: Sumitomo Chemical Company, Limited, Tokyo 104-8260 (JP)
(72) Inventor: HIROYAMA, Yuichi, Tsukuba-shi Ibaraki 300-2617 (JP)
(74) Representative: Hart-Davis, Jason
(86) International application number: PCT/JP2008/068519
(87) International publication number: WO 2009/051085

(57) **Abstract**

Provided is a thermoelectric conversion module. This thermoelectric conversion module comprises a pair of substrates facing each other, a plurality of p-type thermoelectric conversion elements and a plurality of n-type thermoelectric conversion elements arranged between the paired substrates, a plurality of electrodes mounted individually on the paired substrates, connecting individual paired end faces of the p-type thermoelectric conversion elements and the n-type thermoelectric conversion elements electrically with each other, and connecting the p-type thermoelectric conversion elements and the n-type thermoelectric conversion elements electrically in series alternately, and a plurality of bonding members for bonding the p-type thermoelectric conversion elements and the n-type thermoelectric conversion elements individually with the electrodes. The thermal expansion coefficients of the p-type thermoelectric conversion elements and the n-type thermoelectric conversion elements are different from each other and the heights of the p-type thermoelectric conversion elements and the n-type thermoelectric conversion elements are different from each other.

## Description

### Technical Field

The present invention relates to a thermoelectric conversion module.

### Background Art

A structure in which p-type and n-type thermoelectric conversion elements between one pair of substrates are bonded with electrodes through bonding members is known as a structure of a thermoelectric conversion module (Japanese Patent Application Laid-Open Publication No. 2006-332443, for instance). In such a thermoelectric conversion module, the p-type thermoelectric conversion element and the n-type thermoelectric conversion element have usually the same shape, as is disclosed in "Research-and-development report of thermoelectric conversion art using expressway bus exhaust gas" of a result report of fiscal 2002, p11 (2003), by New Energy and Industrial Technology Development Organization.

By the way, there is a case in which the thermoelectric conversion module is used in a high-temperature environment such as 400°C, for instance. In this case, there could be a problem that a stress generated in the high-temperature environment causes a fracture such as a crack in a substrate or in a thermoelectric conversion element, or causes a bonding failure such as peeling between the thermoelectric conversion element and the electrode. In order to alleviate the stress generated at the high temperature, Japanese Patent Application Laid-Open Publication No. 2006-332443 discloses a thermoelectric conversion element in which at least one of an upper end face and a lower end face in the p-type and n-type thermoelectric conversion elements is tilted against the surface of the electrode.

### Disclosure of the Invention

However, conventional methods could not sufficiently inhibit the fracture of the substrate or of the thermoelectric conversion element and the bonding failure between the thermoelectric conversion element and the electrode from occurring when having been used in the high-temperature environment.

And so, the present invention is directed at providing a thermoelectric conversion module which can sufficiently inhibit the fracture of the substrate or of the thermoelectric conversion element and the bonding failure between the thermoelectric conversion element and the electrode from occurring when having been used in the high-temperature environment.

As a result of an investigation, the present inventors have found that a major factor of the fracture and the bonding failure exists in that thermal expansion coefficients of the p-type and the n-type thermoelectric conversion elements are different from each other.

For this reason, the thermoelectric conversion module according to the present invention comprises a pair of substrates facing each other, a plurality of p-type thermoelectric conversion elements and a plurality of n-type thermoelectric conversion elements arranged between the paired substrates, a plurality of electrodes mounted individually on the paired substrates, connecting individual paired end faces of the p-type thermoelectric conversion elements and the n-type thermoelectric conversion elements electrically with each other, and connecting the plurality of the p-type thermoelectric conversion elements and the plurality of the n-type thermoelectric conversion elements electrically in series alternately, and a plurality of bonding members for bonding the p-type thermoelectric conversion elements and the n-type thermoelectric conversion elements individually with the electrodes, wherein the thermal expansion coefficients of the p-type thermoelectric conversion elements and the n-type thermoelectric conversion elements are different from each other and the heights of the p-type thermoelectric conversion elements and the n-type thermoelectric conversion elements are different from each other. In the present invention, the height of the thermoelectric conversion elements means the length of the thermoelectric conversion elements in a direction perpendicular to the substrate.

According to the present invention, the heights of the n-type thermoelectric conversion elements and the heights of the p-type thermoelectric conversion elements are different from each other. Thereby, the total thickness of a pair of bonding members existing on the upper and lower sides of any one of the p-type thermoelectric conversion elements and the total thickness of a pair of bonding members existing on the upper and lower sides of any one of the n-type thermoelectric conversion elements can be differentiated from each other. Consequently, the total expansion amount in a height direction of the p-type thermoelectric conversion element and the pair of the bonding members existing on the upper and lower sides of the p-type thermoelectric conversion element can be approached to the total expansion amount in a height direction of the n-type thermoelectric conversion element and the pair of the bonding members existing on the upper and lower sides of the n-type thermoelectric conversion element, in comparison with the case in which the heights of the n-type thermoelectric conversion element and the p-type thermoelectric conversion element are equal, by using a difference of the thermal expansion coefficient between the bonding members and the thermoelectric conversion elements. In addition, according to the present invention, the heights of the p-type thermoelectric conversion elements and the heights of the n-type thermoelectric conversion elements are different from each other. Thereby, the total thickness of parts of a pair of electrodes existing on the upper and lower sides of any one of the p-type thermoelectric conversion elements, the parts facing the p-type thermoelectric conversion element, and the total thickness of parts of a pair of electrodes existing on the upper and lower sides of any one of the n-type thermoelectric conversion elements, the parts facing the n-type thermoelectric conversion element, can be differentiated from each other. Consequently, the total expansion amount in a height direction of the p-type thermoelectric conversion element and the pair of the electrodes existing on the upper and lower sides of the p-type thermoelectric conversion element can be approached to the total expansion amount in a height direction of the n-type thermoelectric conversion element and the pair of the electrodes existing on the upper and lower sides of the n-type thermoelectric conversion element, in comparison with those in the case in which the heights of the n-type thermoelectric conversion element and the p-type thermoelectric conversion element are equal, by using a difference of the thermal expansion coefficient between these electrodes and the thermoelectric conversion elements.

Therefore, the stresses generated in the thermoelectric conversion elements, the substrates, and the bonding members between the thermoelectric conversion elements and electrodes can be reduced.

It is preferable that the thermal expansion coefficient of the bonding members be larger than the thermal expansion coefficients of the p-type thermoelectric conversion elements and the n-type thermoelectric conversion elements, and the height of the thermoelectric conversion elements having a larger thermal expansion coefficient of the p-type thermoelectric conversion elements and the n-type thermoelectric conversion elements be higher than the height of the thermoelectric conversion elements having a smaller thermal expansion coefficient, or that the thermal expansion coefficient of the bonding members be smaller than the thermal expansion coefficients of the p-type thermoelectric conversion elements and the n-type thermoelectric conversion elements, and the height of the thermoelectric conversion elements having a larger thermal expansion coefficient of the p-type thermoelectric conversion elements and the n-type thermoelectric conversion elements be lower than the height of the thermoelectric conversion elements having a smaller thermal expansion coefficient.

When the thermal expansion coefficient of the bonding members is larger than the thermal expansion coefficients of the p-type thermoelectric conversion elements and the n-type thermoelectric conversion elements, the following effects can be shown by setting the height of the thermoelectric conversion elements having a larger thermal expansion coefficient so as to be higher than that of the thermoelectric conversion elements having a smaller thermal expansion coefficient.

In the thermoelectric conversion elements having the smaller thermal expansion coefficient, the height of any one of them is lower than the height of any one of the thermoelectric conversion elements having a larger thermal expansion coefficient, and the bonding members bonded with the upper and lower faces of any one of the thermoelectric conversion elements can take over the height corresponding to the difference. In other words, the total thickness of a pair of the bonding members located on the thermoelectric conversion element having a smaller thermal expansion coefficient can be set so as to be larger than that of a pair of the bonding members located on the thermoelectric conversion element having a larger thermal expansion coefficient. Accordingly, the expansion amount of the bonding members having a larger thermal expansion coefficient than any one of the thermoelectric conversion elements can be increased and the total expansion amount of the thermoelectric conversion element and the pair of the bonding members can be increased, in the side of the thermoelectric conversion element having a smaller thermal expansion coefficient. Therefore, a difference between the total thermal expansion amount of the thermoelectric conversion element and the pair of the bonding members in the side of the thermoelectric conversion element having the smaller thermal expansion coefficient and the total expansion amount of the thermoelectric conversion element and the pair of the bonding members in the side of the thermoelectric conversion element having the larger thermal expansion coefficient can be reduced, in comparison with those in the case in which the heights of the n-type and the p-type thermoelectric conversion elements are equal.

On the contrary, when the thermal expansion coefficient of the bonding members is smaller than the thermal expansion coefficients of the p-type thermoelectric conversion elements and the n-type thermoelectric conversion elements, the following effects can be shown by setting the height of the thermoelectric conversion elements having a larger thermal expansion coefficient so as to be lower than that of the thermoelectric conversion elements having a smaller thermal expansion coefficient.

In the thermoelectric conversion elements having the larger thermal expansion coefficient, the height of any one of them is lower than the height of any one of the thermoelectric conversion elements having a smaller thermal expansion coefficient, and the bonding members bonded with the upper and lower faces of any one of the thermoelectric conversion elements can take over the height corresponding to the difference. In other words, the total thickness of a pair of the bonding members located on the thermoelectric conversion element having a larger thermal expansion coefficient can be set so as to be larger than that of a pair of the bonding members located on the thermoelectric conversion element having a smaller thermal expansion coefficient. Accordingly, the ratio of the bonding members having a smaller thermal expansion coefficient than any one of the thermoelectric conversion elements increases, and the total thermal expansion amount of the thermoelectric conversion element and the pair of the bonding members can be reduced, in the side of the thermoelectric conversion element having a larger thermal expansion coefficient. Therefore, a difference between the total thermal expansion amount of the thermoelectric conversion element and the pair of the bonding members in the side of the thermoelectric conversion element having the smaller thermal expansion coefficient and the total expansion amount of the thermoelectric conversion element and the pair of the bonding members in the side of the thermoelectric conversion element having the larger thermal expansion coefficient can be reduced.

It is preferable that the thermal expansion coefficient of the electrode be larger than the thermal expansion coefficients of the p-type thermoelectric conversion elements and the n-type thermoelectric conversion elements, and the height of the thermoelectric conversion elements having a larger thermal expansion coefficient of the p-type thermoelectric conversion elements and the n-type thermoelectric conversion elements be higher than the height of the thermoelectric conversion elements having a smaller thermal expansion coefficient, or that the thermal expansion coefficient of the electrode be smaller than the thermal expansion coefficients of the p-type thermoelectric conversion elements and the n-type thermoelectric conversion elements, and the height of the thermoelectric conversion elements having a larger thermal expansion coefficient of the p-type thermoelectric conversion elements and the n-type thermoelectric conversion elements be lower than the height of the thermoelectric conversion elements having a smaller thermal expansion coefficient.

When the thermal expansion coefficient of the electrode is larger than the thermal expansion coefficients of the p-type thermoelectric conversion elements and the n-type thermoelectric conversion elements, the following effects can be shown by setting the height of the thermoelectric conversion elements having a larger thermal expansion coefficient so as to be higher than that of the thermoelectric conversion elements having a smaller thermal expansion coefficient.

In the thermoelectric conversion elements having the smaller thermal expansion coefficient, the height of any one of them is lower than the height of any one of the thermoelectric conversion elements having a larger thermal expansion coefficient, and the electrodes bonded with the upper and lower faces of this thermoelectric conversion element through the bonding members can take over the height corresponding to the difference. In other words, the total thickness of parts of a pair of electrodes connected to any one of the thermoelectric conversion elements having a smaller thermal expansion coefficient, the parts facing the thermoelectric conversion element to which the electrodes are connected, can be set so as to be larger than the total thickness of parts of a pair of electrodes connected to any one of the thermoelectric conversion elements having a larger thermal expansion coefficient, the parts facing the thermoelectric conversion element to which the electrodes are connected. Accordingly, the expansion amount of the electrode having a larger thermal expansion coefficient than any thermoelectric conversion element can be increased and the total expansion amount of the thermoelectric conversion element and the pair of the electrodes can be increased, in the side of the thermoelectric conversion element having a smaller thermal expansion coefficient. Therefore, a difference between the total thermal expansion amount of the thermoelectric conversion element and the pair of the electrodes in the side of the thermoelectric conversion element having a smaller thermal expansion coefficient and the total expansion amount of the thermoelectric conversion element and the pair of the electrodes in the side of the thermoelectric conversion element having a larger thermal expansion coefficient can be reduced, in comparison with those in the case in which the heights of the n-type and the p-type thermoelectric conversion elements are equal.

On the contrary, when the thermal expansion coefficient of the electrode is smaller than the thermal expansion coefficients of the p-type thermoelectric conversion elements and the n-type thermoelectric conversion elements, the following effects can be shown by setting the height of the thermoelectric conversion elements having a larger thermal expansion coefficient so as to be lower than that of the thermoelectric conversion elements having a smaller thermal expansion coefficient.

In the thermoelectric conversion elements having the larger thermal expansion coefficient, the height of any one of them is lower than the height of any one of the thermoelectric conversion elements having a smaller thermal expansion coefficient, and the electrodes bonded with the upper and lower faces of any one of the thermoelectric conversion elements through the bonding members can take over the height corresponding to the difference. In other words, the total thickness of parts of a pair of electrodes connected to any one of the thermoelectric conversion elements having a larger thermal expansion coefficient, the parts facing the thermoelectric conversion element to which the electrodes are connected, can be set so as to be larger than the total thickness of parts of a pair of electrodes connected to any one of the thermoelectric conversion elements having a smaller thermal expansion coefficient, the parts facing the thermoelectric conversion element to which the electrodes are connected. Accordingly, the ratio of the electrode having a smaller thermal expansion coefficient than any thermoelectric conversion element increases, and the total thermal expansion amount of the thermoelectric conversion element and the pair of the electrodes can be reduced, in the side of the thermoelectric conversion element having a larger thermal expansion coefficient. Therefore, a difference between the total thermal expansion amount of the thermoelectric conversion element and the pair of the electrodes in the side of the thermoelectric conversion element having the smaller thermal expansion coefficient and the total expansion amount of the thermoelectric conversion element and the pair of the electrodes in the side of the thermoelectric conversion element having the larger thermal expansion coefficient can be reduced.

It is preferable that the p-type thermoelectric conversion elements be a p-type thermoelectric conversion elements containing Ca₃Co₄O₉, and the n-type thermoelectric conversion elements be an n-type thermoelectric conversion elements containing CaMnO₃.

Ca₃Co₄O₉ which is used as the p-type thermoelectric conversion elements and CaMnO₃ which is used as the n-type thermoelectric conversion elements can be used in the atmosphere under a high temperature. Therefore, the thermoelectric conversion elements are useful as thermoelectric conversion elements of a thermoelectric conversion module which is used particularly at a high temperature of 400°C or higher.

### Brief Description of the Drawings

Figure 1 is a sectional view of a thermoelectric conversion module 1 according to a first embodiment;
Figure 2 is a sectional view of a thermoelectric conversion module 1 according to a second embodiment; and
Figure 3 is a sectional view of a thermoelectric conversion module 1 according to a third embodiment.

### Description of Symbols

1 thermoelectric conversion module, 2 first substrate, 3 p-type thermoelectric conversion element, 4 n-type thermoelectric conversion element, 6 second electrode, 7 second substrate, 8 first electrode, 9a 9b, 9c, 9d bonding members, 10 thermoelectric conversion element.

### Best Modes for Carrying Out the Invention

Preferred embodiments according to the present invention will be described below with reference to the attached drawings. In the description for the drawings, the same reference numerals will be put on the same or corresponding element, and overlapping descriptions will be omitted. In addition, a dimensional ratio in each drawing does not necessarily match an actual dimensional ratio.

### First Embodiment

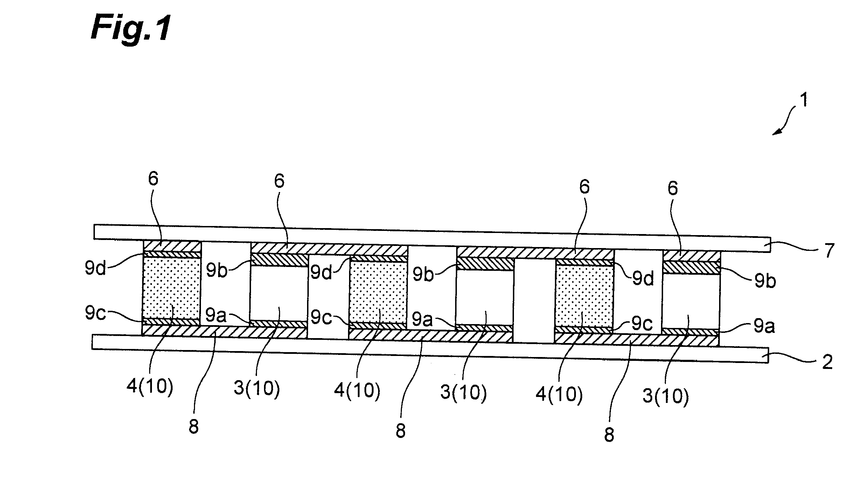

Figure 1 illustrates a sectional view of a thermoelectric conversion module 1 in a first embodiment. As is illustrated in Figure 1, the thermoelectric conversion module 1 comprises a first substrate 2, a first electrode 8, a thermoelectric conversion element 10, a second electrode 6 and a second substrate 7.

The first substrate 2 has, for instance, a rectangular shape, has electrically insulating properties and thermal conductance, and covers one ends of a plurality of the thermoelectric conversion elements 10. Examples of the materials for this first substrate include alumina, aluminum nitride and magnesia.

The first electrode 8 is provided on the first substrate 2, and electrically connects one end faces of mutually adjacent thermoelectric conversion elements 10 with each other. This first electrode 8 can be formed at a predetermined position on the first substrate 2, for instance, with a thin film method such as sputtering and vapor deposition, and with a method such as screen printing, plating and thermal spraying. Alternatively, a metal plate having a predetermined shape and the like may be bonded onto the first substrate 2 with soldering, brazing or the like, for instance. A material of the first electrode 8 is not limited in particular as long as the material has electroconductivity, but is preferably a metal containing at least one element selected from the group consisting of titanium, vanadium, chromium, manganese, iron, cobalt, nickel, copper, molybdenum, silver, palladium, gold, tungsten and aluminum as a main component, from the viewpoint of enhancing the heat resistance, the corrosion resistance and the adhesiveness to the thermoelectric element of the electrode. Here, the main component means a component of which the content in the electrode material is 50% by volume or more. In the first electrode 8, a part facing the p-type thermoelectric conversion element 3 and a part facing the n-type thermoelectric conversion element 4 have mutually the same thickness.

The thermoelectric conversion element 10 is, for instance, a rod-like member having a rectangular cross-section, and there are two types of the p-type thermoelectric conversion element 3 and the n-type thermoelectric conversion element 4.

A material constituting each thermoelectric conversion element 10 is not limited in particular, and usable materials include various materials such as a metal and a metal oxide.

Examples of the p-type materials include a mixed metal oxide such as NaCo₂O₄ and Ca₃Co₄O₉; a silicide such as MnSi_{1.73}, Fe₁₋ₓMnₓSi₂, Si_{0.8}Ge_{0.2} and β-FeSi₂; and a skutterudite such as CoSb₃, FeSb₃ and RFe₃CoSb₁₂, wherein R represents La and Ce or Yb; and an alloy containing Te such as BiTeSb, PbTeSb, Bi₂Te₃ and PbTe.

In addition, examples of the n-type material includes a mixed metal oxide such as SrTiO₃, Zn₁₋ₓAlₓO, CaMnO₃, LaNiO₃, BaTiO₃ and Ti₁₋ₓNbₓO; a silicide such as Mg₂Si, Fe₁₋ₓCoₓSi₂, Si_{0.8}Ge_{0.2} and β-FeSi₂; a skutterudite; a clathrate compound such as Ba₈Al₁₂Si₃₀ and Ba₈Al₁₂Ge₃₀; a boron compound such as CaB₆, SrB₆, BaB₆ and CeB₆; and an alloy containing Te such as BiTeSb, PbTeSb, Bi₂Te₃ and PbTe.

It is preferable that the p-type thermoelectric conversion element 3 be a p-type thermoelectric conversion element made from Ca₃Co₄O₉, and the n-type thermoelectric conversion element 4 be an n-type thermoelectric conversion element made from CaMnO₃, from the viewpoint of being used in an air atmosphere under a high temperature.

The thermal expansion coefficients of the p-type thermoelectric conversion element 3 and the n-type thermoelectric conversion element 4 are different from each other. In the present embodiment, the case will be described in detail, in which the thermal expansion coefficient of the n-type thermoelectric conversion element 4 is larger than the thermal expansion coefficient of the p-type thermoelectric conversion element 3.

The second substrate 7 has, for instance, a rectangular shape, and covers the other ends side of the thermoelectric conversion elements 10. The second substrate 7 is also arranged in parallel to the first substrate 2 so as to face the first substrate 2. The second substrate 7 is not limited in particular as long as the second substrate 7 has electrically insulating properties and thermal conductance similarly to the first substrate 2, and examples of the materials include alumina, aluminum nitride and magnesia.

The second electrode 6 electrically connects the other end faces of mutually adjacent thermoelectric conversion elements 10 with each other, and can be formed on the lower face of the second substrate 7, for instance, with a thin film method such as sputtering and vapor deposition, and with a method such as screen printing, plating and thermal spraying, similarly to the first electrode 8. Alternatively, a metal plate having a predetermined shape and the like may be bonded onto the second substrate 7 with soldering, brazing or the like, for instance. The material of the second electrode 6 is also similar to that of the first electrode 8. The thermoelectric conversion elements 10 are electrically connected in series by the second electrode 6 and the first electrode 8 provided in the lower end face side of the thermoelectric conversion elements 10. In the second electrode 6, a part facing the p-type thermoelectric conversion element 3 and a part facing the n-type thermoelectric conversion element 4 have mutually the same thickness.

The p-type thermoelectric conversion element 3 and the n-type thermoelectric conversion element 4 are alternately arranged between the first substrate 2 and the second substrate 7, and both faces of these elements are fixed on the surfaces of the corresponding first electrode 8 and the second electrode 6 by the bonding members 9a, 9b, 9c and 9d formed of an AuSb-based or PbSb-based solder, a silver paste or the like. Consequently, the conversion elements are electrically connected in series as a whole. These bonding members are preferably solid while being used as the thermoelectric conversion element module. Here, the bonding member 9a bonds the p-type thermoelectric conversion element 3 with the first electrode 8, the bonding member 9b bonds the p-type thermoelectric conversion element 3 with the second electrode 6, the bonding member 9c bonds the n-type thermoelectric conversion element 4 with the first electrode 8, and the bonding member 9d bonds the n-type thermoelectric conversion element 4 with the second electrode 6.

The p-type thermoelectric conversion element 3 and the n-type thermoelectric conversion element 4 may have a metal layer individually on those upper and bottom surfaces. In other words, when each thermoelectric conversion element 10 is bonded with the electrodes 6 and 8 by the bonding members 9a to 9d, metal layers are previously formed respectively on the surfaces to be bonded with the electrodes 6 and 8 out of the surface of each thermoelectric conversion element 10, and then these metal layers may be respectively bonded with the electrodes 6,8 through the bonding members 9a to 9d, so as to enhance the bonding properties between each thermoelectric conversion element 10 and the bonding members 9a to 9d.

If the metal layers are formed on the surfaces to be bonded with the electrodes 6 and 8 out of the surface of each thermoelectric conversion element 10, these metal layers and the electrodes 6 and 8 can be easily bonded by the bonding members 9a to 9d, and besides, the metal layers show adequate adhesiveness to each thermoelectric conversion element 10. As a result, a thermoelectric conversion module 1 having higher connection reliability and lower contact resistance can be realized. Accordingly, the power generation efficiency of the thermoelectric conversion module 1 can be enhanced.

Particularly, when each thermoelectric conversion element 10 is composed of a material containing a metal oxide, it is often difficult to bond the thermoelectric conversion element with the electrode. Accordingly, it is particularly preferable to form the metal layer beforehand. However, it is often difficult by itself to previously form a metal layer having high adhesiveness on the surface of the thermoelectric conversion element containing a metal oxide, and an abnormal bonding tends to easily occur between the thermoelectric conversion element and the electrode. Therefore, when at least one conduction type of thermoelectric conversion element 10 of the p-type thermoelectric conversion element 3 and the n-type thermoelectric conversion element 4 is constituted by a material containing the metal oxide, a target metal layer can be formed by heating the thermoelectric conversion element to a specific temperature and spraying a powder of a metal oxide or a metal carbonate thereon, which contains a metal constituting the metal layer that is desired to be formed.

In the present embodiment, the thermal expansion coefficient of the bonding members 9a to 9d is larger than the thermal expansion coefficients of the p-type thermoelectric conversion element 3 and the n-type thermoelectric conversion element 4. The heights of two conduction types of the thermoelectric conversion elements 3 and 4 are individually set so that the height of the n-type thermoelectric conversion element 4 having a larger thermal expansion coefficient of the p-type and the n-type thermoelectric conversion elements 10 is higher than the height of the p-type thermoelectric conversion element 3 having a smaller thermal expansion coefficient. Here, the height is a length in a direction perpendicular to substrates 7 and 2.

An example of a combination of the thermoelectric conversion element and the bonding member which satisfy the above described condition includes an example of using Ca₃Co₄O₉ as a material of the p-type thermoelectric conversion element, CaMnO₃ as a material of the n-type thermoelectric conversion element and a sintered Ag paste as a material of the bonding member. The thermal expansion coefficients of these materials are sequentially 1.3 × 10⁻⁵/K, 1.5 × 10⁻⁵/K and 1.8 × 10⁻⁵/K, in a range of room temperature to 700°C.

The pair of the substrates 2, 7 constituting the thermoelectric conversion module 1 faces each other in parallel, and the thicknesses of the electrodes 6 and 8 are constant. Therefore, the total thickness of the n-type thermoelectric conversion element 4 and the pair of the bonding members 9c, 9d in the side of the n-type thermoelectric conversion element 4 having a larger thermal expansion coefficient and the total thickness of the p-type thermoelectric conversion element 3 and the pair of the bonding members 9a, 9b in the side of the p-type thermoelectric conversion element 3 having a smaller thermal expansion coefficient become equal to each other, at room temperature before the thermoelectric conversion module is used under high temperature. Accordingly, the total thickness of the pair of the bonding members 9a and 9b in the side of the p-type thermoelectric conversion element 3 having a smaller thermal expansion coefficient results in being larger than the total thickness of the pair of the bonding members 9c and 9d in the side of the n-type thermoelectric conversion element 4 having a larger thermal expansion coefficient.

In the above present embodiment, it is preferable to make each thickness of the bonding members 9a and 9c to be bonded with the bottom faces of the thermoelectric conversion elements 3, 4 equal, and make the thicknesses of the bonding members 9b and 9d to be bonded with the upper face different from each other, as is illustrated in Figure 1, from the viewpoint of making a method of manufacturing the thermoelectric conversion module 1 as simple as possible. However, the manufacture can be implemented, for instance, even by making the thicknesses of the bonding members 9a and 9b equal and respectively thicker than the thicknesses of the bonding members 9c and 9d.

According to the present embodiment, the height of the n-type thermoelectric conversion element 4 having a larger thermal expansion coefficient is set so as to be higher than the height of the p-type thermoelectric conversion element 3 having a smaller thermal expansion coefficient. Thereby, the total thickness of the bonding members 9a, 9b showing a larger thermal expansion coefficient than the n-type and the p-type thermoelectric conversion elements in the side of the p-type thermoelectric conversion element 3 having a smaller thermal expansion coefficient results in being larger than the total thickness of the bonding members 9c, 9d in the side of the n-type thermoelectric conversion element 4. Accordingly, the total thermal expansion amount in a height direction of the p-type thermoelectric conversion element 3 and the pair of the bonding members 9a, 9b and the total thermal expansion amount in a height direction of the n-type thermoelectric conversion element 4 and the pair of the bonding members 9c, 9d can be closer values to each other, in comparison with those in the case in which the heights of the n-type thermoelectric conversion element and the p-type thermoelectric conversion element are equal.

Thereby, even if there is a difference of the thermal expansion amount between the p-type thermoelectric conversion element 3 and the n-type thermoelectric conversion element 4, a bending stress onto substrates 2, 7 hardly occurs, and a stress onto the thermoelectric conversion element 10 and the bonding members 9a to 9d also hardly occurs. Accordingly, a thermoelectric conversion module 1 can be manufactured which can sufficiently inhibit an occurrence of a fracture such as a crack in the substrates 2, 7 and the thermoelectric conversion elements 3, 4, a bonding failure due to the peeling or the like of the bonding members 9a to 9d, and the peeling between the electrodes 6, 8 and the substrates 2, 7, and shows high connection reliability.

Incidentally, in the present embodiment, the case is described in which the thermal expansion coefficient of the n-type thermoelectric conversion element 4 is larger than the thermal expansion coefficient of the p-type thermoelectric conversion element 3. However, the thermal expansion coefficient of the p-type thermoelectric conversion element 3 may be larger than the thermal expansion coefficient of the n-type thermoelectric conversion element 4. In this case, similar function and effect are shown if the height of the p-type thermoelectric conversion element 3 having a relatively large thermal expansion coefficient is set so as to be higher than the height of the n-type thermoelectric conversion element 4 having a relatively small thermal expansion coefficient.

In addition, in the present embodiment, the thermal expansion coefficient of the electrodes 6, 8 may be larger than, smaller than or even equal to the thermal expansion coefficients of the p-type thermoelectric conversion element 3 and the n-type thermoelectric conversion element 4. Furthermore, in the electrodes 6, 8, a part facing the p-type thermoelectric conversion element 3 and a part facing the n-type thermoelectric conversion element 4 are set so as to have mutually the same thickness. However, the manufacture can be implemented even by setting the thicknesses different from each other.

### Second Embodiment

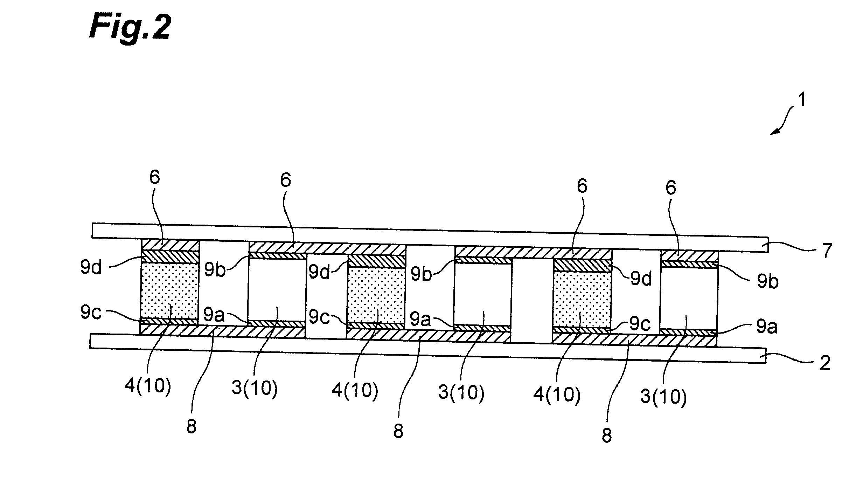

Figure 2 illustrates a sectional view of a thermoelectric conversion module 1 in a second embodiment.

The first point at which the thermoelectric conversion module 1 according to the second embodiment is different from the thermoelectric conversion module 1 according to the first embodiment is a point that thermal expansion coefficient of the bonding members 9a to 9d is smaller than thermal expansion coefficients of the p-type thermoelectric conversion element 3 and the n-type thermoelectric conversion element 4. The second point is a point that the height of the n-type thermoelectric conversion element 4 having a larger thermal expansion coefficient of the p-type thermoelectric conversion element 3 and the n-type thermoelectric conversion element 4 is set so as to be lower than the height of the p-type thermoelectric conversion element 3 having a smaller thermal expansion coefficient.

Because the height of the n-type thermoelectric conversion element 4 having a larger thermal expansion coefficient is set so as to be lower than the height of the p-type thermoelectric conversion element 3 having a smaller thermal expansion coefficient, the bonding members 9c, 9d having a smaller thermal expansion coefficient than the thermal expansion coefficients of the n-type thermoelectric conversion element 4 and the p-type thermoelectric conversion element 3, in the pair of the bonding members 9c, 9d in the side of the n-type thermoelectric conversion element 4 having a larger thermal expansion coefficient, can take over the length by which the height of the n-type thermoelectric conversion element 4 is set so as to be lower than the height of the p-type thermoelectric conversion element. Therefore, the whole expansion amount in the height direction of the n-type thermoelectric conversion element 4 and the pair of the bonding members 9c, 9d can be alleviated.

Thereby, even though there is a difference of the thermal expansion amounts between the p-type thermoelectric conversion element 3 and the n-type thermoelectric conversion element 4, a bending stress onto substrates 2, 7 hardly occurs, and stresses are also hardly applied to the thermoelectric conversion element 10 and the bonding members 9a to 9d, similarly to the first embodiment. Accordingly, a thermoelectric conversion module 1 can be manufactured which can sufficiently inhibit an occurrence of a fracture such as a crack in the substrates 2, 7 and the thermoelectric conversion elements 3, 4, a bonding failure due to the peeling or the like of the bonding members 9a to 9d, and the peeling between the electrodes 6, 8 and the substrates 2, 7, and shows high connection reliability.

### Third Embodiment

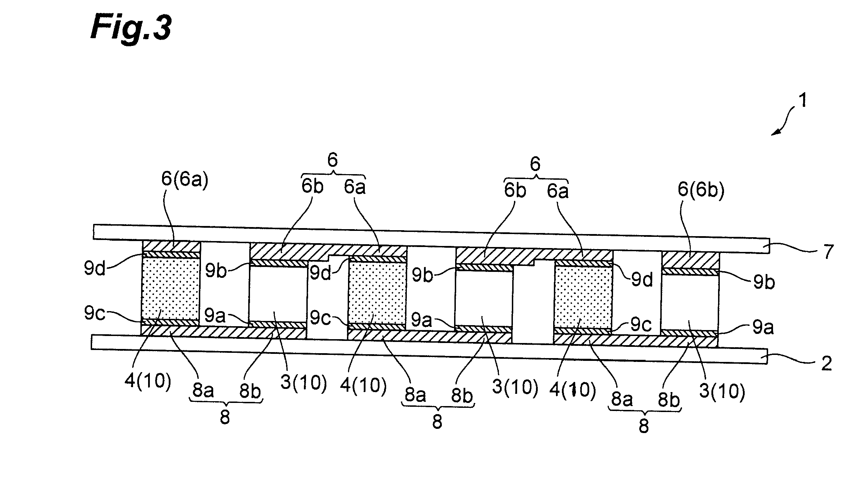

Figure 3 illustrates a sectional view of a thermoelectric conversion module 1 in a third embodiment.

The points at which the thermoelectric conversion module 1 according to the third embodiment is different from the thermoelectric conversion module 1 according to the first embodiment is a point that the total thickness of the pair of the bonding members 9a, 9b in the side of the p-type thermoelectric conversion element 3 having a smaller thermal expansion coefficient is equal to the total thickness of the pair of the bonding members 9c, 9d in the side of the n-type thermoelectric conversion element 4 having a larger thermal expansion coefficient, and a point that the total thickness of parts 6a, 8a of a pair of electrodes 6, 8 connected to the n-type thermoelectric conversion element 4 having a larger thermal expansion coefficient, the parts 6a, 8a facing the thermoelectric conversion element 4 to which the electrodes 6, 8 are connected, is smaller than the total thickness of parts 6b, 8b of a pair of electrodes 6, 8 connected to the p-type thermoelectric conversion element 3 having a smaller thermal expansion coefficient, the parts 6b, 8b facing the thermoelectric conversion element 3 to which the electrodes 6, 8 are connected. In addition, in the present embodiment, the thermal expansion coefficient of the electrodes 6, 8 needs to be larger than the thermal expansion coefficients of the p-type thermoelectric conversion element 3 and the n-type thermoelectric conversion element 4.

Specifically, in the present embodiment, each electrode 6 has a step, and the thickness of a part 6b facing the p-type thermoelectric conversion element 3 is set so as to be thicker than the thickness of a part 6a facing the n-type thermoelectric conversion element 4.

According to the present embodiment, the height of the n-type thermoelectric conversion element 4 having a larger thermal expansion coefficient is set so as to be higher than the height of the p-type thermoelectric conversion element 3 having a smaller thermal expansion coefficient, and furthermore, the total thickness of parts 6b, 8b facing the p-type thermoelectric conversion element 3 in electrodes 6, 8 showing a larger thermal expansion coefficient than the n-type and the p-type thermoelectric conversion elements, in the side of the p-type thermoelectric conversion element 3 having a smaller thermal expansion coefficient, is set so as to be larger than the total thickness of parts 6a, 8a facing the n-type thermoelectric conversion element 4. Accordingly, the total thermal expansion amount in a height direction of the p-type thermoelectric conversion element 3 and the parts 6b, 8b of the electrodes 6, 8 and the total thermal expansion amount in the height direction of the n-type thermoelectric conversion element 4 and the parts 6a, 8a of the electrodes 6, 8 can be closer values to each other, in comparison with those in the case in which the heights of the n-type and the p-type thermoelectric conversion elements are set so as to be equal.

Thereby, even though there is a difference of the thermal expansion amounts between the p-type thermoelectric conversion element 3 and the n-type thermoelectric conversion element 4, a bending stress onto substrates 2, 7 hardly occurs, and stresses are also hardly applied to the thermoelectric conversion element 10 and the bonding members 9a to 9d, similarly to the first embodiment. Accordingly, a thermoelectric conversion module 1 can be manufactured which can sufficiently inhibit an occurrence of a fracture such as a crack in the substrates 2, 7 and in the thermoelectric conversion elements 3, 4, a bonding failure due to the peeling or the like of the bonding members 9a to 9d, and the peeling between the electrodes 6, 8 and the substrates 2, 7, and shows high connection reliability.

Incidentally, in the present embodiment, the step is provided in the second electrode 6 so that the thicknesses are differentiated between the part 6b in the side of the p-type thermoelectric conversion element 3 and the part 6a in the side of the n-type thermoelectric conversion element 4. However, the step may be provided in the first electrode 8, or the step may also be provided in both of the electrodes 6, 8.

In addition, although not shown in the figure, the thermal expansion coefficient of the electrode may be smaller than the thermal expansion coefficients of the p-type thermoelectric conversion element 3 and the n-type thermoelectric conversion element 4. In this case, the height of the n-type thermoelectric conversion element 4 having a larger thermal expansion coefficient of the p-type thermoelectric conversion element 3 and the n-type thermoelectric conversion element 4 is set so as to be lower than the height of the p-type thermoelectric conversion element 3 having a smaller thermal expansion coefficient. Furthermore, the thicknesses in the electrodes 6, 8 are set uneven so that the total thickness of parts of a pair of electrodes 6, 8 connected to the n-type thermoelectric conversion element 4 having a larger thermal expansion coefficient, the parts facing the n-type thermoelectric conversion element 4 to which the electrodes 6, 8 are connected, could be larger than the total thickness of parts of a pair of electrodes 6, 8 connected to the p-type thermoelectric conversion element 3 having a smaller thermal expansion coefficient, the parts facing the p-type thermoelectric conversion element 3 to which the electrodes 6, 8 are connected. Thereby, similar function and effect to the second embodiment are shown.

In addition, the thermal expansion coefficient of the bonding members 9a to 9d may be larger than, smaller than or even equal to the thermal expansion coefficients of the p-type thermoelectric conversion element 3 and the n-type thermoelectric conversion element 4. In addition, the manufacture can be implemented even if the total thickness of the bonding members 9a, 9b in the p-type thermoelectric conversion element 3 is not equal to the total thickness of the bonding members 9c, 9d in the n-type thermoelectric conversion element 4.

Incidentally, in the present embodiment, the case was described in which the thermal expansion coefficient of the n-type thermoelectric conversion element 4 is larger than the thermal expansion coefficient of the p-type thermoelectric conversion element 3. However, the thermal expansion coefficient of the p-type thermoelectric conversion element 3 may be larger than the thermal expansion coefficient of the n-type thermoelectric conversion element 4. In this case, similar function and effect are shown if the height of the p-type thermoelectric conversion element 3 having a relatively large thermal expansion coefficient is set so as to be higher than the height of the n-type thermoelectric conversion element 4 having a relatively small thermal expansion coefficient.

In the above, preferred embodiments in the present invention are specifically described, but the present invention is not limited to these embodiments. In addition, the present invention is not limited to the above described embodiments, but can be variously modified.

For instance, in the first embodiment and the second embodiment, the thermal expansion coefficient of the bonding members 9a to 9d does not necessarily need to be larger or smaller than the thermal expansion coefficients of both of the n-type thermoelectric conversion element 4 and the p-type thermoelectric conversion element 3. The present invention can be implemented even when the thermal expansion coefficient of the bonding members 9a to 9d is larger than the thermal expansion coefficient of one conductive type of the thermoelectric conversion element and are smaller than the thermal expansion coefficient of the other conductive type of the thermoelectric conversion element. In this case, if the height of the thermoelectric conversion element having a smaller thermal expansion coefficient is set so as to be lower than the height of the thermoelectric conversion element having a larger thermal expansion coefficient, or the height of the thermoelectric conversion element having a larger thermal expansion coefficient is set so as to be lower than the height of the thermoelectric conversion element having a smaller thermal expansion coefficient, the total thermal expansion amounts in a height direction of the thermoelectric conversion elements and the bonding members become closer values to each other, in comparison with those in the case in which the heights of the p-type thermoelectric conversion element and the n-type thermoelectric conversion element are equal to each other. Therefore, such a modified embodiment is also preferably used.

In addition, each material of the bonding members 9a, 9b and the bonding members 9c, 9d in the first embodiment and the second embodiment may be varied depending on the conductive type of the thermoelectric conversion element, as long as the materials are selected in such a range that a relationship of magnitude among the thermal expansion coefficients of the bonding members and the thermal expansion coefficients of the p-type and the n-type thermoelectric conversion elements is not changed. Furthermore, for instance, each material of the electrodes 6, 8 may be varied depending on the conductive type of the thermoelectric conversion element.

In addition, for instance, in the third embodiment, the value of the thermal expansion coefficient of the electrodes 6, 8 does not necessarily need to be larger or smaller than the values of the thermal expansion coefficients of both of the n-type thermoelectric conversion element 4 and the p-type thermoelectric conversion element 3. The present invention can be implemented even when the thermal expansion coefficient of the electrodes 6, 8 is larger than the thermal expansion coefficient of one conductive type of the thermoelectric conversion element and is smaller than the thermal expansion coefficient of the other conductive type of the thermoelectric conversion element. In this case, if the height of the thermoelectric conversion element having a smaller thermal expansion coefficient is set so as to be lower than the height of the thermoelectric conversion element having a larger thermal expansion coefficient, or the height of the thermoelectric conversion element having a larger thermal expansion coefficient is set so as to be lower than the height of the thermoelectric conversion element having a larger thermal expansion coefficient, the total thermal expansion amounts in a height direction of the thermoelectric conversion elements and the electrodes become closer values to each other, in comparison with those in the case in which the heights of the p-type thermoelectric conversion element and the n-type thermoelectric conversion element are equal to each other. Therefore, such a modified embodiment is also preferably used.

In addition, each material of the electrodes 6, 8 in the third embodiment may be varied as long as the materials are selected in such a range that a relationship of magnitude among the thermal expansion coefficient of the electrodes and the thermal expansion coefficients of the p-type and the n-type thermoelectric conversion elements is not changed. In addition, for instance, each material of the bonding members 9a, 9b and the bonding members 9c, 9d may be varied depending on the conductive type of the thermoelectric conversion element.

Furthermore, for instance, in the first embodiment and the second embodiment, the thickness of the bonding members for the n-type thermoelectric conversion element is differentiated from that for the p-type thermoelectric conversion element, on the basis of a relationship of magnitude among the thermal expansion coefficients of the p-type and the n-type thermoelectric conversion elements and the thermal expansion coefficient of the bonding members, and in the third embodiment, the thickness of the electrodes for the n-type thermoelectric conversion element is differentiated from that for the p-type thermoelectric conversion element, on the basis of a relationship of magnitude among the thermal expansion coefficients of the p-type and the n-type thermoelectric conversion elements and the thermal expansion coefficient of the electrodes. However, in the first embodiment and the second embodiment, the thickness of the electrodes for the p-type thermoelectric conversion element may be differentiated from that of the n-type thermoelectric conversion element, on the basis of a relationship of magnitude among the thermal expansion coefficients of the p-type and the n-type thermoelectric conversion elements and the thermal expansion coefficient of the electrodes as in the third embodiment, or in the third embodiment, the thickness of the bonding members for the n-type thermoelectric conversion element may be further differentiated from that of the p-type thermoelectric conversion element, on the basis of a relationship of magnitude among the thermal expansion coefficients of the p-type and the n-type thermoelectric conversion elements and the thermal expansion coefficient of the bonding members, as in the first embodiment and the second embodiment.

### Industrial Applicability

The present invention provides a thermoelectric conversion module which can sufficiently inhibit the occurrence of the fracture of the substrate or of the thermoelectric conversion element and the bonding failure between the thermoelectric conversion element and the electrode.

## Claims

1. A thermoelectric conversion module comprising:
a pair of substrates facing each other;
a plurality of p-type thermoelectric conversion elements and a plurality of n-type thermoelectric conversion elements arranged between the paired substrates;
a plurality of electrodes mounted individually on the paired substrates, connecting individual paired end faces of the p-type thermoelectric conversion elements and the n-type thermoelectric conversion elements electrically with each other, and connecting the plurality of the p-type thermoelectric conversion elements and the plurality of the n-type thermoelectric conversion elements electrically in series alternately; and
a plurality of bonding members for bonding the p-type thermoelectric conversion elements and the n-type thermoelectric conversion elements individually with the electrodes, wherein
the thermal expansion coefficients of the p-type thermoelectric conversion elements and the n-type thermoelectric conversion elements are different from each other and the heights of the p-type thermoelectric conversion elements and the n-type thermoelectric conversion elements are different from each other.

2. The thermoelectric conversion module according to claim 1, wherein
the thermal expansion coefficient of the bonding members is larger than the thermal expansion coefficients of the p-type thermoelectric conversion elements and the n-type thermoelectric conversion elements, and
the height of the thermoelectric conversion elements having a larger thermal expansion coefficient of the p-type thermoelectric conversion elements and the n-type thermoelectric conversion elements is higher than the height of the thermoelectric conversion elements having a smaller thermal expansion coefficient,
or,
the thermal expansion coefficient of the bonding members is smaller than the thermal expansion coefficients of the p-type thermoelectric conversion elements and the n-type thermoelectric conversion elements, and
the height of the thermoelectric conversion elements having a larger thermal expansion coefficient of the p-type thermoelectric conversion elements and the n-type thermoelectric conversion elements is lower than the height of the thermoelectric conversion elements having a smaller thermal expansion coefficient.

3. The thermoelectric conversion module according to claim 1, wherein
the thermal expansion coefficient of the bonding members is larger than the thermal expansion coefficients of the p-type thermoelectric conversion elements and the n-type thermoelectric conversion elements, and
the height of the thermoelectric conversion elements having a larger thermal expansion coefficient of the p-type thermoelectric conversion elements and the n-type thermoelectric conversion elements is higher than the height of the thermoelectric conversion elements having a smaller thermal expansion coefficient, and the thickness of a pair of the bonding members located on any one of the thermoelectric conversion elements having a larger thermal expansion coefficient of the p-type thermoelectric conversion elements and the n-type thermoelectric conversion elements is smaller than the thickness of a pair of the bonding members located on any one of the thermoelectric conversion elements having a smaller thermal expansion coefficient,
or,
the thermal expansion coefficient of the bonding members is smaller than the thermal expansion coefficients of the p-type thermoelectric conversion elements and the n-type thermoelectric conversion elements, and
the height of the thermoelectric conversion elements having a larger thermal expansion coefficient of the p-type thermoelectric conversion elements and the n-type thermoelectric conversion elements is lower than the height of the thermoelectric conversion elements having a smaller thermal expansion coefficient, and the thickness of a pair of the bonding members located on any one of the thermoelectric conversion elements having a larger thermal expansion coefficient of the p-type thermoelectric conversion elements and the n-type thermoelectric conversion elements is larger than the thickness of a pair of the bonding members located on any one of the thermoelectric conversion elements having a smaller thermal expansion coefficient.

4. The thermoelectric conversion module according to claim 1, wherein
the thermal expansion coefficient of the electrodes is larger than the thermal expansion coefficients of the p-type thermoelectric conversion elements and the n-type thermoelectric conversion elements, and
the height of the thermoelectric conversion elements having a larger thermal expansion coefficient of the p-type thermoelectric conversion elements and the n-type thermoelectric conversion elements is higher than the height of the thermoelectric conversion elements having a smaller thermal expansion coefficient,
or,
the thermal expansion coefficient of the electrodes is smaller than the thermal expansion coefficients of the p-type thermoelectric conversion elements and the n-type thermoelectric conversion elements, and
the height of the thermoelectric conversion elements having a larger thermal expansion coefficient of the p-type thermoelectric conversion elements and the n-type thermoelectric conversion elements is lower than the height of the thermoelectric conversion elements having a smaller thermal expansion coefficient.

5. The thermoelectric conversion module according to claim 1, wherein
the thermal expansion coefficient of the electrodes is larger than the thermal expansion coefficients of the p-type thermoelectric conversion elements and the n-type thermoelectric conversion elements, and
the height of the thermoelectric conversion elements having a larger thermal expansion coefficient of the p-type thermoelectric conversion elements and the n-type thermoelectric conversion elements is higher than the height of the thermoelectric conversion elements having a smaller thermal expansion coefficient, and the total thickness of parts of a pair of electrodes connected to any one of the thermoelectric conversion elements having a larger thermal expansion coefficient of the p-type thermoelectric conversion elements and the n-type thermoelectric conversion elements, the parts facing the thermoelectric conversion element to which the electrodes are connected, is smaller than the total thickness of parts of a pair of electrodes connected to any one of the thermoelectric conversion elements having a smaller thermal expansion coefficient, the parts facing the thermoelectric conversion element to which the electrodes are connected,
or
the thermal expansion coefficient of the electrodes is smaller than the thermal expansion coefficients of the p-type thermoelectric conversion elements and the n-type thermoelectric conversion elements, and the height of the thermoelectric conversion elements having a larger thermal expansion coefficient of the p-type thermoelectric conversion elements and the n-type thermoelectric conversion elements is lower than the height of the thermoelectric conversion elements having a smaller thermal expansion coefficient, and the total thickness of parts of a pair of electrodes connected to any one of the thermoelectric conversion elements having a larger thermal expansion coefficient of the p-type thermoelectric conversion elements and the n-type thermoelectric conversion elements, the parts facing the thermoelectric conversion element to which the electrodes are connected, is larger than the total thickness of parts of a pair of electrodes connected to any one of the thermoelectric conversion elements having a smaller thermal expansion coefficient, the parts facing the thermoelectric conversion element to which the electrodes are connected.

6. The thermoelectric conversion module according to any one of claims 1 to 5, wherein the p-type thermoelectric conversion elements are p-type thermoelectric conversion elements containing Ca₃Co₄O₉, and the n-type thermoelectric conversion elements are n-type thermoelectric conversion elements containing CaMnO₃.
